# EUROPEAN PATENT APPLICATION

(11) **EP 4 513 566 A1**
(43) Date of publication of application: **26.02.2025**
(21) Application number: 23193449.8
(22) Date of filing: 25.08.2023
(51) Int. Cl.: H01L 29/06, H01L 23/31, H01L 29/16, H01L 29/861, H01L 29/872, H01L 21/329, H01L 29/78, H01L 21/336

(54) **SEMICONDUCTOR DEVICE HAVING AN IMPROVED TERMINATION AREA, AS WELL AS A CORRESPONDING MANUFACTURING METHOD AND POWER DEVICE**

(71) Applicant: Nexperia B.V., 6534 AB Nijmegen (NL)
(72) Inventor: Mazzillo, Massimo Cataldo, Hamburg (DE); El-Zammar, Georgio, Hamburg (DE); Böttcher, Tim, 22529 Hamburg (DE); Urresti Ibanez, Jesus Roberto, 22529 Hamburg (DE)
(74) Representative: Pjanovic, Ilija

(57) **Abstract**

A semiconductor device, comprising a semiconductor body comprising a semiconductor substrate and an epitaxial layer formed on the semiconductor substrate, said epitaxial layer being of the first conductivity type, and wherein an active area and a termination area adjacent the active area are arranged in the epitaxial layer, wherein said termination area comprises a plurality of laterally spaced apart first regions, said first regions being of the second conductivity type opposite to said first conductivity type, each of said plurality of first regions enclosing, observed from a top view of said semiconductor device, said active area and one or more second regions, wherein said second regions are comprised in between said plurality of spaced apart first regions, respectively, wherein said one or more second regions extend further into said epitaxial layer than said plurality of spaced apart first regions, and wherein said one or more second regions comprise an insulation material for insulating said plurality of spaced apart first regions from one another.

## Description

### Technical field

The present disclosure generally relates to the field of semiconductor devices and, more specifically, to the edge termination of an active area of a semiconductor device.

### Background

Edge termination is an important part of power devices. Most of planar and trench power devices are based on one or several PN-type junctions. When the active part of the junction ends on the lateral side of the device, a very high electric field may appear under reverse voltage biasing, due to junction curvature or trench corners.

A periphery protection, called edge termination may be required. Reliable and robust high voltage devices may need effective edge termination structures to protect the device periphery, so that blocking values close to the ideal 1D avalanche voltage value can be achieved.

Several physical limitations make SiC edge terminations quite complex to design. The main limitation is the low diffusion coefficients of dopant atoms inside the semiconductor. Deep junction, for example > 1µm, may be difficult to implement and lateral dopants diffusion may be very limited. Moreover, the higher interface traps level observed in the SiC/passivation interface compared to Silicon may also affect the efficiency of the standard Si terminations architectures in the SiC power devices.

Charges may accumulate at the interface, generating breakdown voltage instabilities and early failures, especially with temperature. Finally, the termination design may also be relevant to be able to reach high avalanche ruggedness to comply with applications prone to unclamped inductive switching, UIS.

P+ floating guard rings (Kao Rings) implemented in a n-doped substrate have been proposed in the past, among all the possible termination structures integrated on SiC power devices. The width and distance of P rings increase when the distance to active area increases, i.e. towards the end of the diode or saw lane.

In standard implementations, P+ floating rings are integrated by implanting P-type impurities, for example Al, onto an N doped epitaxial layer. However, the limited junction depth achievable on SiC and high crystal damage arising from the use of high dose implants, necessary for the poor activation of the P dopant push to find suitable alternatives for floating ring designs compatible with the definition of the P doped area by epitaxy and not only by implantation.

On one hand, in fact, the process limitations described above put some limits for proper termination design and on the other hand the high surface damage produced by the implantation process combined to passivation charges can produce breakdown voltage instabilities and early failures when the device operates under high stressing conditions, for example high humidity, temperature or voltage.

Furthermore, highly doped channel stopper regions around the saw lane area may be used to avoid the depletion and/or inversion of the semiconductor, due to passivation charges. If not properly designed, some leakage paths can occur at the interface between passivation and termination, ultimately leading to reduced blocking voltage and sometimes early failures. The termination design would undoubtedly benefit from the integration of additional features preventing layer inversion in the termination area.

### Summary

It is an object of the present disclosure to provide for a semiconductor device that has an improved termination area.

It would further be advantageous to achieve a corresponding method and power device.

In a first aspect of the present disclosure, there is provided a semiconductor device, comprising:
a semiconductor body comprising a semiconductor substrate and an epitaxial layer formed on the semiconductor substrate, said epitaxial layer being of the first conductivity type, and wherein an active area and a termination area adjacent the active area are arranged in the epitaxial layer;
wherein said termination area comprises:
   a plurality of laterally spaced apart first regions, said first regions being of the second conductivity type opposite to said first conductivity type, each of said plurality of first regions enclosing, observed from a top view of said semiconductor device, said active area;
   one or more second regions, wherein said second regions are comprised in between said plurality of spaced apart first regions, respectively, wherein said one or more second regions extend further into said epitaxial layer than said plurality of spaced apart first regions, and wherein said one or more second regions comprise an insulation material for insulating said plurality of spaced apart first regions from one another.

In other words, the present disclosure is directed to a termination concept which integrates P-type floating rings defined by, for example, SiC etching process, thus compatible with the definition of the P doped region by epitaxy or implantation. The examples discussed below include recessed N+ implanted regions at the bottom of the trenches between contiguous P-type floating rings. In some other examples, further P+ doped regions are defined on top of the P type floating rings between the N doped implanted regions.

The first regions enclose, observed from the top view of the semiconductor device, the active area. This may mean that the first regions may loop around the active area, for example in the shape of a circle rectangle, ellipse, or anything alike.

The active area of a semiconductor device contains the functional components, such as transistors, diodes, or other functional elements, where the desired electrical or electronic functions take place. On the other hand, the termination area is the portion of the device that lies beyond the active area and serves specific purposes related to device performance and protection.

The primary function of the termination area is to provide a controlled transition from the active area to the surrounding environment. It helps manage electric field distribution and prevent undesirable effects, such as electrical breakdown or leakage, that can occur at the edges or periphery of the active area.

In high-voltage semiconductor devices, such as SiC-based power devices, the termination area is particularly important. It is designed to distribute the electric field more evenly and reduce the concentration of electric field lines at the edges. This helps prevent voltage crowding or field-induced breakdown, enhancing the breakdown voltage and overall device performance.

The present disclosure defines a plurality of laterally spaced apart first regions, for example three, four or five different laterally spaced apart regions. These regions may be obtained by etching of a uniformly P doped termination region. This will be explained in more detail with reference to the figures.

The second regions are provided in between the first regions. The second regions extend deeper in the semiconductor body compared to the first regions. The second regions comprise insulation material for insulating the different first regions from one another.

The second regions may extend further into the epitaxial layer than the plurality fo spaced apart first regions, for example by at least 150%.

In an advantageous example, there are at least three laterally spaced apart first regions.

The doping concentration of the first region may be between 1 E17cm-3 and 5E17cm-3. The doping concentration may be 10 to 50 times higher than the doping concentration of the epitaxial layer. The thickness of the first region may be somewhere between 0.2 µm - 0.5 µm.

In an example, the plurality of laterally spaced apart first regions are floating.

Floating means that the first regions are not connected to any specific electrical potential or reference point. In other words, it is not electrically tied to any voltage source or ground.

For example, a P-type floating ring can act as a voltage isolation structure. By leaving it floating, it may help electrically isolate or separate different regions or components within the semiconductor device, preventing undesired electrical coupling or interference. This isolation can be important to ensure proper device functionality and avoid unwanted electrical interactions.

The floating ring may be designed to shape or control the electric field distribution within the terminal area. Its floating nature allows it to modify the electric field gradients or patterns, influencing the electrical behavior of the device. This can help optimize performance, enhance breakdown voltage, reduce electric field crowding, or mitigate other electric field-related effects.

In a further example, each of said plurality of spaced apart first regions are uniformly doped.

In another example, the semiconductor device further comprises:
at least one inversion protection layer provided at a bottom side of said one or more second regions, respectively, wherein said inversion protection layer is of said first conductivity type, wherein a doping concentration of said inversion protection layer is higher than a doping concentration of said epitaxial layer.

The inventors have found that it may be beneficial to provide an inversion protection layer at the bottom side of the one or more second regions. Such an inversion protection layer may prevent inversion of the epitaxial layer. The doping concentration of the inversion protection layer is then also higher compared to the doping concentration of the epitaxial layer.

In a further example, the semiconductor device comprises at least two inversion protection layers, and wherein doping concentrations of said at least two inversion protection layers increase away from said active area.

In another example, the doping of said at least two inversion protection layers is between 1 E17cm-3 and 5E17cm-3.

It is further noted that it may be advantageous if the doping concentration of the at least two inversion protection layers increases by increasing lateral distances from the active area.

In a further example, at least one first region of said plurality of laterally spaced apart first regions has a top side having a higher doping concentration than a bottom side.

These regions prevent surface depletion and eventually the inversion of the P floating rings, i.e. the first regions, due to the surface charges induced by the passivation deposition.

The combination of the inversion protection layers in between the first regions on the epitaxial layer and P+ enrichment layers on top of the P doped rings, i.e. the top side of the first region is higher doped compared to the bottom side, in the termination guarantees a more stable termination behavior towards surface charges, especially on high voltage devices and in harsh environmental conditions, for example high temperature and humidity.

In another example, the insulation material is any of:
- Thermal Oxide;
- Tetraethyl orthosilicate, TEOS;
- Silane Oxide;
- Silicon Oxynitride, SiON;
- Silicon Nitride, SiN.

In another example, the semiconductor body comprises Silicon Carbide, SiC.

SiC has unique properties that make it highly suitable for power electronic applications. It exhibits a wide bandgap, which allows it to handle higher voltages and operate at higher temperatures compared to traditional semiconductor materials such as silicon, Si. This wide bandgap property enables SiC power devices to have lower switching losses, higher breakdown voltages, and higher thermal conductivity.

SiC power devices offer advantages such as higher efficiency, improved power density, and enhanced performance in high-temperature environments. They are used in various power electronic systems, including power supplies, motor drives, electric vehicles, renewable energy systems, and high-voltage applications.

SiC-based power devices include diodes, metal-oxide-semiconductor field-effect transistors, MOSFETs, junction field-effect transistors, JFETs, and insulated-gate bipolar transistors, IGBTs. These devices leverage SiCs material properties to achieve higher power conversion efficiency, higher operating frequencies, and reduced energy losses.

In yet another example, the spacings between said plurality of laterally spaced apart first regions increase in a lateral direction away from said active area.

In a further example, the semiconductor device comprises any of:
- a SiC Power device;
- a SiC Merged PIN Schottky diode;
- a SiC Metal Oxide Semiconductor, MOS, Field Effect Transistor, FET, MOSFET;
- a SiC PN Diode;
- a SiC Barrier Schottky Diode.

In yet another example, the first conductivity type corresponds to N-type and said second conductivity type corresponds to P-type.

In a second aspect of the present disclosure, there is provided a method of manufacturing a semiconductor device in accordance with any of the previous claims, wherein said method comprises the steps of:
- providing said plurality of laterally spaced apart first regions, said first regions being of the second conductivity type opposite to said first conductivity type, each of said plurality of first regions enclosing, observed from a top view of said semiconductor device, said active area;
- providing said one or more second regions, wherein said second regions are comprised in between said plurality of spaced apart first regions, respectively, wherein said one or more second regions extend further into said epitaxial layer than said plurality of spaced apart first regions, and wherein said one or more second regions comprise an insulation material for insulating said plurality of spaced apart first regions from one another.

It is noted that the advantages as explained with reference to the first aspect of the present disclosure, being the semiconductor device, are also applicable to the second aspect of the present disclosure, being the method of manufacturing such a semiconductor device.

In an example, each of said plurality of spaced apart first regions are uniformly doped.

In a further example, the method further comprises the step of:
- providing at least one inversion protection layer at a bottom side of said one or more second regions, respectively, wherein said inversion protection layer is of said first conductivity type, wherein a doping concentration of said inversion protection layer is higher than a doping concentration of said epitaxial layer.

In a third aspect of the present disclosure, there is provided a power device comprising a semiconductor device in accordance with any of the examples provided above.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the drawings

Fig. 1a discloses a cross section of an example of a semiconductor device in accordance with the present disclosure;
Fig. 1b discloses a top view of an example of a semiconductor device in accordance with the present disclosure;
Fig. 2a discloses a cross section of another example of a semiconductor device in accordance with the present disclosure;
Fig. 2b discloses a top view of another example of a semiconductor device in accordance with the present disclosure;
Fig. 3a discloses a cross section of yet another example of a semiconductor device in accordance with the present disclosure;
Fig. 3b discloses a top view of yet another example of a semiconductor device in accordance with the present disclosure;
Figs. 4a - 4I disclose method steps of manufacturing a semiconductor device in accordance with the present disclosure.

### Detailed Description

It is noted that in the description of the figures, same reference numerals refer to the same or similar components performing a same or essentially similar function.

A more detailed description is made with reference to particular examples, some of which are illustrated in the appended drawings, such that the manner in which the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

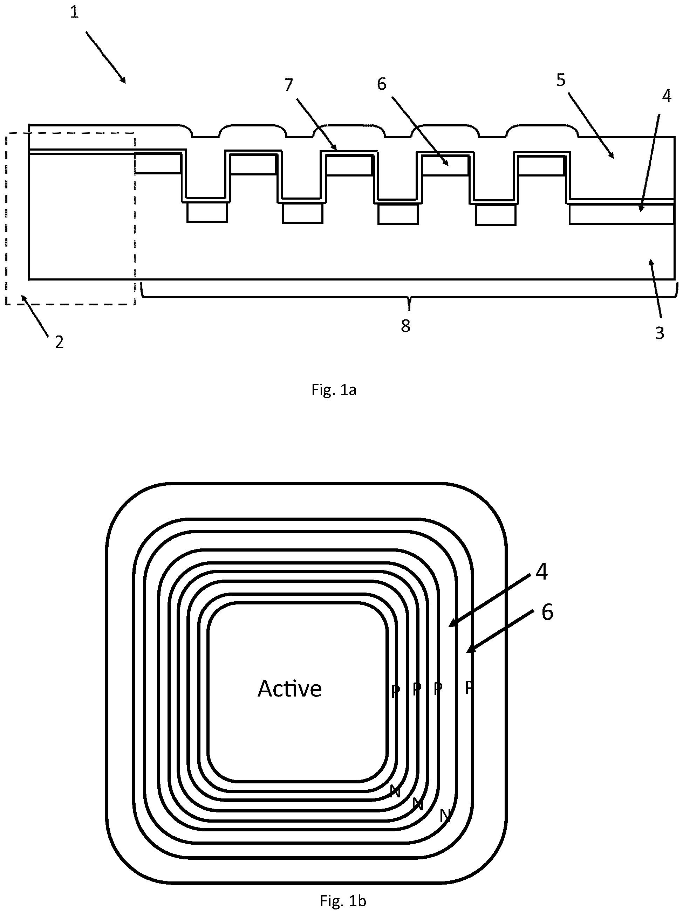

Fig. 1a discloses a cross section 1 of an example of a semiconductor device in accordance with the present disclosure and Fig. 1b discloses a top view 11 of an example of a semiconductor device in accordance with the present disclosure.

The epitaxial layer is indicated with reference numeral 3. The active area is indicated with reference numeral 1. The termination area is indicated with reference numeral 8. The plurality of first regions is indicated with reference numeral 6. An oxide layer is indicated with reference numeral 7. The insulation material is indicated with reference numeral 5. The inversion protection layer is indicated with reference numeral 4.

It is noted that the same reference numerals are used throughout the figures for improving the readability of the present disclosure.

The example shown in figure 1 shows a P floating ring termination 6 where the rings are formed by etching the P-type layer defined by epitaxy or implantation. The depth of the recessed regions is deeper than that of the P type region in the termination.

This example also shows an N+ enrichment layer 4 defined by implantation at the bottom of trenches between adjacent P rings. The passivation 5 is formed by a thin SiO2 layer and a stack of further dielectric layers. The SiO2 layer is used to passivate the dangling bonds in SiC recessed regions after the etching process while the outer passivation layer, preferably SiN or SiON protect the termination from the moisture and other external contaminants.

This termination design is compatible with the definition of the P doped region by epitaxy with consequent removal of any limitation due to the implantation process on SiC, i.e. low implanted depth and poor implanted doping activation, as the doping in the epi layer does not need to be activated at high temperatures as it happens for the implanted doping.

Further, the structure may benefit from the integration of an N+ enrichment layer at the bottom of the trenches between adjacent P rings, preventing the inversion of the low doped epilayer in the highly defective recessed region defined by dry etching and ensuring in this way higher ruggedness to surface charges.

In this example, the trenches may have a depth between 0.5µm and 1.5 µm and a spacing between 1µm and 3µm. The spacing of the trenches may increase from the active area to the saw lane. The P-doped layer and N+ enrichment may have both a thickness in the range 0.2 µm to 0.5 µm. The doping of the P layer and N+ enrichment regions can be both from 10 to 50 times higher than the epilayer doping, in this example N epilayer doping may be 1E16 cm-3, P and N+ layer doping may both be between 1E17cm-3 and 5E17 cm-3, and preferably the doping of the N+ layer is lower than that of the P doped layer.

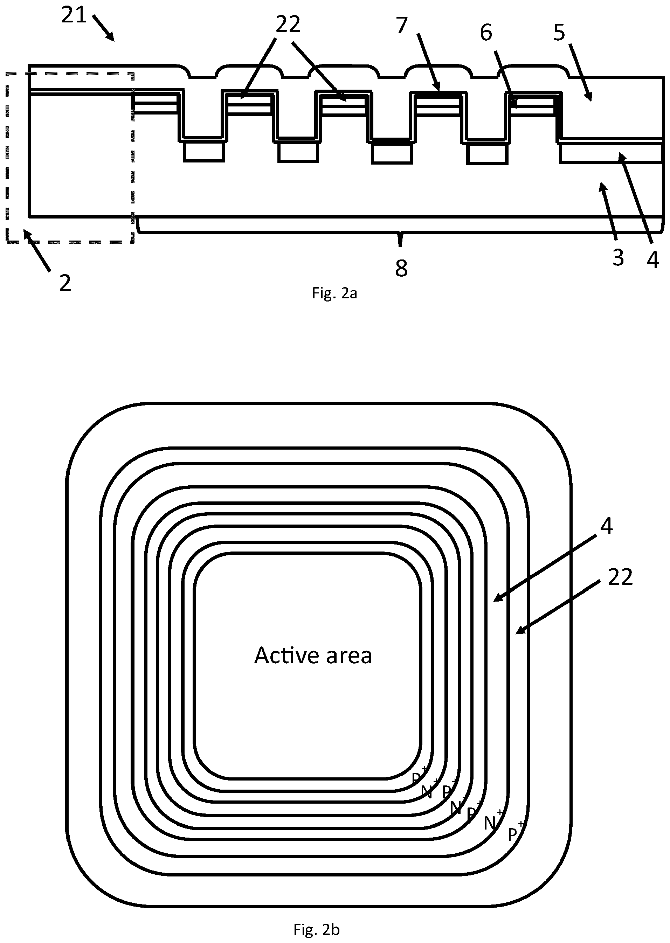

Fig. 2a discloses a cross section of another example 21 of a semiconductor device in accordance with the present disclosure and fig. 2b discloses a top view 31 of another example of a semiconductor device in accordance with the present disclosure.

The example shown in figure 2 is characterized by the same features disclosed in the example shown in figure 1 with the addition of further P+ doped enrichment regions 22 on top of the floating rings. These regions prevent the surface depletion and eventually the inversion of the P floating rings, due to the surface charges induced by the passivation deposition. The P+ enrichment layer can be defined by epitaxy or implantation and may have a thickness between for example 0.05µm and 0.2 µm and a doping between 1E18 cm-3 and 5E19 cm-3.

The combination N+ enrichment layers in the recessed regions on the epitaxial layer and P+ enrichment layers on top of the P doped rings in the termination guarantees a more stable termination behavior towards surface charges, especially on high voltage devices and in harsh environmental conditions, i.e. high temperature and humidity.

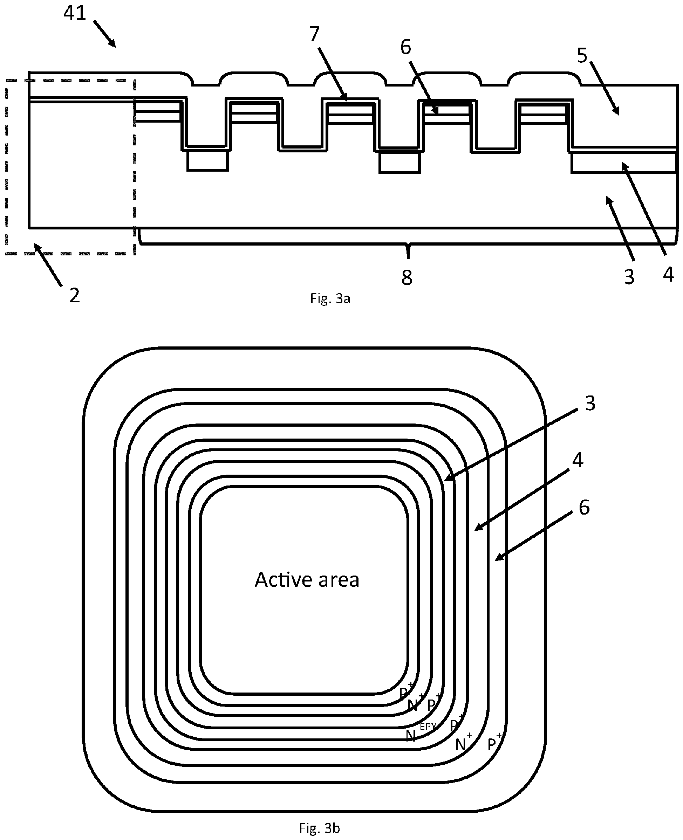

Fig. 3a discloses a cross section 41 of yet another example of a semiconductor device in accordance with the present disclosure, and Fig. 3b discloses a top view 51 of yet another example of a semiconductor device in accordance with the present disclosure.

The example shown in figure 3 shows the same features already disclosed in the example shown in figure 1. However, in this case the N+ regions are not defined in between each couple of floating rings and can eventually have different doping, for example the doping can be higher close to the saw lane, i.e. N++ layer with doping in 1E18 cm-3-5E19 cm-3 range. In that case, different implantation processes may be used to define N regions with different doping.

The structure disclosed in this example may also be compatible with P+ type enrichment regions on top of the P-type floating rings. In this case, the P+ enrichment regions may not be defined on top of every floating ring, provided that the P+ layer is implanted. This embodiment is characterized by a lower amount of implanted regions with consequent benefits in terms of relatively low implant damage.

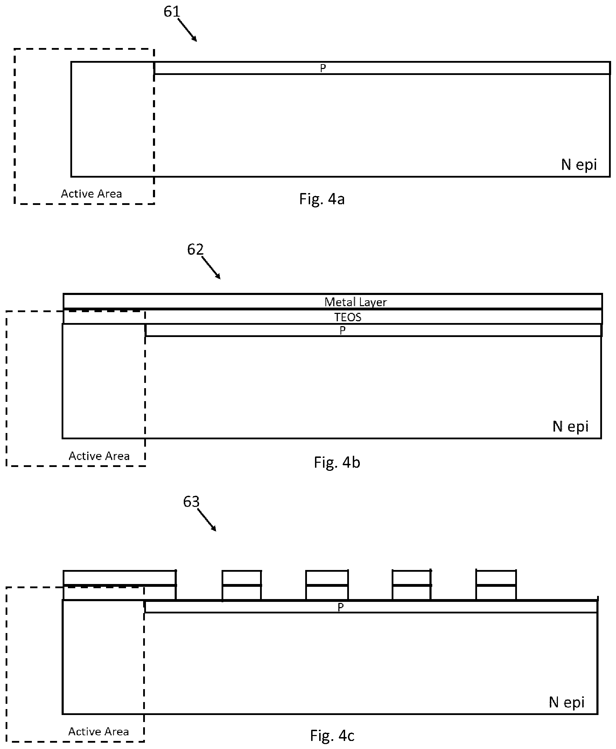

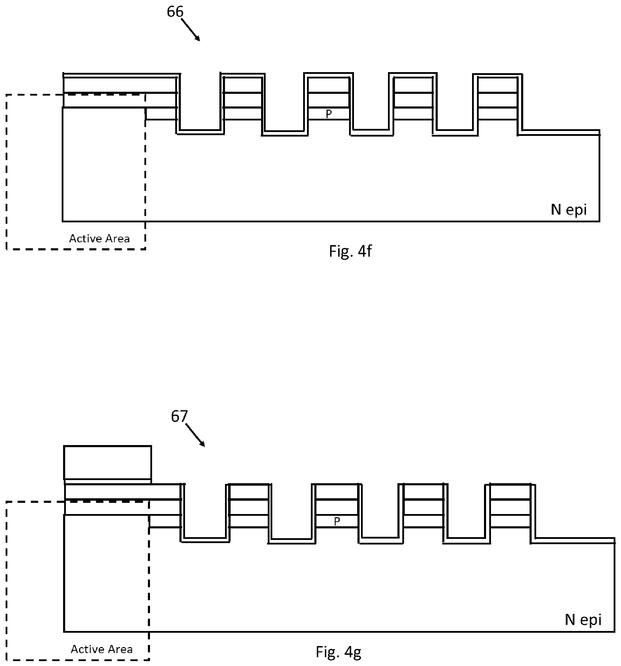

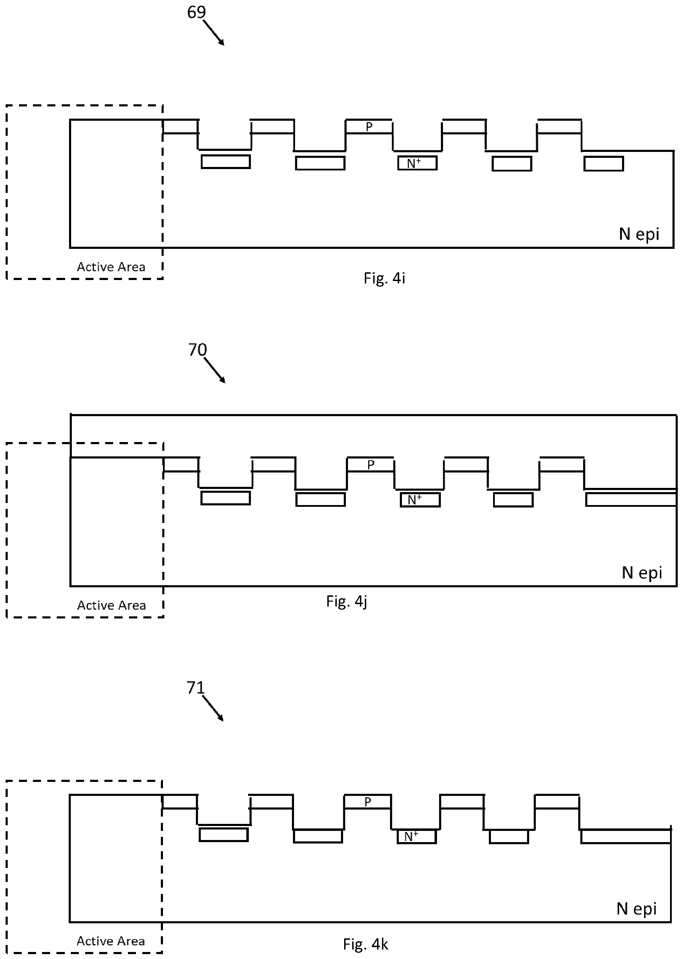

Figs. 4a - 4l disclose method steps 61, 62, 63, 64 ,65, 66, 67 and 68 of manufacturing a semiconductor device in accordance with the present disclosure.

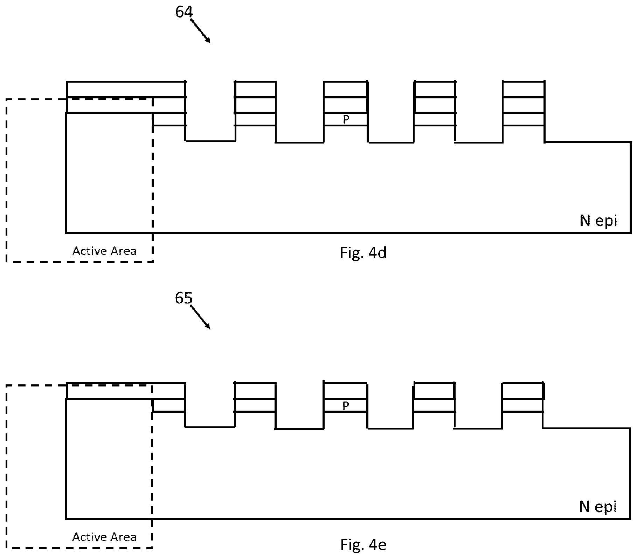

First a Junction Termination Extension is provided in the EPI later (fig. 4a). Then, TEOS deposition and metal layer hard mask deposition is performed (fig. 4b). This is followed by either Photolitography, metal dry etching, TEOS dry etching and/or resist stripping to form the intermediate product as shown in figure 4c. Next, a further etching step is performed to etch the epi layer, which results in the intermediate product shown in figure 4d. Then, a Metal Wet Etch is performed (fig. 4e) and a Screen Oxide TEOS deposition is performed (fig, 4f). Finally, a Photolitography and a poly spacer dry etch process is performed, as shown in fig. 4G and an N-type implant may be performed as shown in fig. 4h.

To reduce the number of claims, certain aspects of the technology are presented below in certain claim forms, but the applicant contemplates the various aspects of the technology in any number of claim forms. For example, while some aspect of the technology may be recited as a computer-readable medium claim, other aspects may likewise be embodied as a computer-readable medium claim, or in other forms, such as being embodied in a means-plus-function claim.

In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A semiconductor device, comprising:
a semiconductor body comprising a semiconductor substrate and an epitaxial layer formed on the semiconductor substrate, said epitaxial layer being of the first conductivity type, and wherein an active area and a termination area adjacent the active area are arranged in the epitaxial layer;
wherein said termination area comprises:
a plurality of laterally spaced apart first regions, said first regions being of the second conductivity type opposite to said first conductivity type, each of said plurality of first regions enclosing, observed from a top view of said semiconductor device, said active area;
one or more second regions, wherein said second regions are comprised in between said plurality of spaced apart first regions, respectively, wherein said one or more second regions extend further into said epitaxial layer than said plurality of spaced apart first regions, and wherein said one or more second regions comprise an insulation material for insulating said plurality of spaced apart first regions from one another.

2. A semiconductor device in accordance with claim 1, wherein said second regions extend further into said epitaxial layer than said plurality of spaced apart first regions by at least 150%.

3. A semiconductor device in accordance with any of the previous claims, wherein said plurality of laterally spaced apart first regions are floating.

4. A semiconductor device in accordance with any of the previous claims, wherein each of said plurality of spaced apart first regions are uniformly doped.

5. A semiconductor device in accordance with any of the previous claims, wherein said semiconductor device further comprises:
at least one inversion protection layer provided at a bottom side of said one or more second regions, respectively, wherein said inversion protection layer is of said first conductivity type, wherein a doping concentration of said inversion protection layer is higher than a doping concentration of said epitaxial layer.

6. A semiconductor device in accordance with claim 1, wherein said semiconductor device comprises at least two inversion protection layers, and wherein doping concentrations of said at least two inversion protection layers increase away from said active area.

7. A semiconductor device in accordance with any of the claims 1 - 4, wherein a doping concentration of said at least two inversion protection layers increases by increasing lateral distances from said active area.

8. A semiconductor device in accordance with any of the previous claims, wherein at least one first region of said plurality of laterally spaced apart first regions has a top side having a higher doping concentration than a bottom side.

9. A semiconductor device in accordance with any of the previous claims, wherein said insulation material is any of:
- Thermal Oxide;
- Tetraethyl orthosilicate, TEOS;
- Silane Oxide;
- Silicon Oxynitride, SiON;
- Silicon Nitride, SiN.

10. A semiconductor device in accordance with any of the previous claims, wherein spacings between said plurality of laterally spaced apart first regions increase in a lateral direction away from said active area.

11. A semiconductor device in accordance with any of the previous claims, wherein said semiconductor device comprises any of:
- a SiC Power device;
- a SiC Merged PIN Schottky diode;
- a SiC Metal Oxide Semiconductor, MOS, Field Effect Transistor, FET, MOSFET;
- a SiC PN Diode;
- a SiC Barrier Schottky Diode.

12. A method of manufacturing a semiconductor device in accordance with any of the previous claims, wherein said method comprises the steps of:
- providing said plurality of laterally spaced apart first regions, said first regions being of the second conductivity type opposite to said first conductivity type, each of said plurality of first regions enclosing, observed from a top view of said semiconductor device, said active area;
- providing said one or more second regions, wherein said second regions are comprised in between said plurality of spaced apart first regions, respectively, wherein said one or more second regions extend further into said epitaxial layer than said plurality of spaced apart first regions, and wherein said one or more second regions comprise an insulation material for insulating said plurality of spaced apart first regions from one another.

13. A method in accordance with claim 9, wherein each of said plurality of spaced apart first regions are uniformly doped.

14. A method in accordance with any of the claims 9 - 10, wherein said method further comprises the step of:
- providing at least one inversion protection layer at a bottom side of said one or more second regions, respectively, wherein said inversion protection layer is of said first conductivity type, wherein a doping concentration of said inversion protection layer is higher than a doping concentration of said epitaxial layer.

15. A power device comprising a semiconductor device in accordance with any of the claims 1 - 11.
